# EUROPEAN PATENT APPLICATION

(11) **EP 4 719 037 A1**
(43) Date of publication of application: **01.04.2026**
(21) Application number: 25203082.0
(22) Date of filing: 18.09.2025
(51) Int. Cl.: H10W 72/50, H10W 44/00, H10W 44/20

(54) **IMPROVED BANDWIDTH FOR WIREBOND INTEGRATED CIRCUIT PACKAGE**

(30) Priority: 18.09.2024 US 202463696148 P; 16.09.2025 US 202519330576
(71) Applicant: Infineon Technologies Americas Corp., El Segundo, CA 90245 (US)
(72) Inventor: Huang, Shaowu, Los Altos, California, 94022 (US); Wu, Dance, Palo Alto, California, 94306 (US)
(74) Representative: Murgitroyd & Company

(57) **Abstract**

An integrated circuit (IC) device comprises a package substrate with traces configured to electrically connect with a plurality of IC device connection mechanisms. An IC die is mounted on the package substrate. The IC die includes pads. Wires electrically connect the pads of the IC die to the traces of the package substrate, including a first wire that electrically connects a first pad of the IC die to the first trace of the package substrate. A first metallic structure of the package substrate is electrically connected to the first trace and is configured to mitigate adverse effects of an inductance of the first wire.

## Description

### Cross References to Related Applications

This application claims the benefit of U.S. Provisional Patent App. No. 63/696,148, entitled "Enhancement of Wirebond Package Bandwidth for Ultra High Speed SerDes Applications," filed on September 18, 2024, the disclosure of which is expressly incorporated herein by reference in its entirety for all purposes.

### Field of Technology

The present disclosure relates generally to semiconductor chip packaging, and more particularly to using wirebond packaging for high frequency communication applications.

### Background

Integrate circuit (IC) dies (or "chips") are encapsulated in an IC package to provide protection from the environment and to facilitate integration of the IC chip into a larger device. To facilitate electronically interfacing with an IC chip, an IC package includes package connection mechanisms such as pins, pads, balls of a ball grid array (BGA), and such package connection mechanisms are electrically connected to pads on the IC chip.

IC chips are typically mounted to a substrate within the IC package (sometimes referred to as a "package substrate") to provide mechanical support, facilitate mechanical assembly of the IC package, facilitate heat dissipation, etc. In many cases, the package substrate includes electrical traces to facilitate electronically interconnecting the IC chip with the package connection mechanisms (e.g., pins, pads, balls, etc.).

One technique for electrically connecting pads on an IC chip with traces on a package substrate or with package connection mechanisms (e.g., pins, pads, balls, etc.) is often referred to as "wire bonding." In a typical wire bonding process, an end of a wire is conductively bonded to a pad on the IC chip. Then, the wire is drawn to and conductively bonded to a pad on the package substrate.

Wirebonding is a well-established technique and is relatively inexpensive as compared to other techniques for electrically connecting pads on an IC chip with traces on a package substrate or with package connection mechanisms. Wirebonding connections, however, tend to experience relatively high inductance, which can cause adverse effects with higher frequency signals, such as high return loss at high frequencies. Thus, wirebonding is not used for IC chips that output or input high frequency signals. For example, the Institute for Electrical and Electronics Engineers (IEEE) Standard 802.3 sets stringent return loss requirements for a 25 GHz (25G) serializer/deserializer (SerDes) that cannot be met by IC chips that utilize conventional wirebonding.

For high frequency applications, the industry typically uses other techniques for electrically connecting pads on an IC chip with traces on a package substrate or with package connection mechanisms. For example, one technique that is often used for high frequency applications is referred to as "Flip Chip." With Flip Chip, the IC chip is fabricated with pads on a surface of the IC chip, and solder balls are deposited on the pads. Additionally, the package substrate is fabricated with pads that correspond and are spatially aligned with the pads on the surface of the IC chip. The IC chip is flipped and positioned so that the solder balls are aligned with the pads on the package substrate. Next, the solder balls are melted to conductively bond the pads on the IC chip to the pads on the package substrate.

### Summary

In an embodiment, an integrated circuit (IC) device comprises: a package substrate having a plurality of traces configured to electrically connect with a plurality of IC device connection mechanisms, the plurality of traces including a first trace, the package substrate also having a first metallic structure electrically connected to the first trace; an IC die mounted on the package substrate, the IC die including a plurality of pads, the plurality of pads including a first pad; and a plurality of wires, each wire of the plurality of wires i) including a respective end attached to a respective pad of the IC die, and ii) being attached to a respective trace among the plurality of traces of the package substrate, the plurality of wires including a first wire electrically connecting the first pad of the IC die to the first trace of the package substrate, wherein the first metallic structure is configured to mitigate adverse effects of a first inductance of the first wire.

In another embodiment, a method for manufacturing an IC device, includes: mounting an IC die to a package substrate, the IC die including a plurality of pads, the plurality of pads including a first pad, the package substrate having a plurality of traces configured to electrically connect with a plurality of IC device connection mechanisms, the plurality of traces including a first trace, the package substrate also having a first metallic structure electrically connected to the first trace; and connecting a plurality of wires between the plurality of pads of the IC die and the traces of the package substrate. Connecting the plurality of wires includes: attaching a first end of a first wire, among the plurality of wires, to the first pad of the IC die; and attaching the first wire to the first trace of the package substrate, wherein the first metallic structure is configured to mitigate adverse effects of a first inductance of the first wire.

### Brief Description of the Drawings

Fig. 1 is a simplified diagram of an example vehicle in which various aspects, features, and elements described herein are implemented in accordance with an embodiment of this disclosure.
Fig. 2A is a simplified block diagram of a top view of a prior art integrated circuit (IC) device that uses wirebonding to electrically connect pads on an IC chip with ball grid array (BGA) balls of the IC device.
Fig. 2B is a diagram showing a simplified electrical circuit corresponding to the IC device of Fig. 2A.
Fig. 3A is a simplified block diagram of a top view of an example IC device that uses a mitigation technique to mitigate adverse effects caused by inductance of wires used in wirebonding, according to an embodiment.
Fig. 3B is a diagram showing a simplified electrical circuit corresponding to the IC device of Fig. 3A, according to an embodiment.
Fig. 4A is a simplified block diagram of a top view of another example IC device that uses a mitigation technique to mitigate adverse effects caused by inductance of wires used in wirebonding, according to another embodiment.
Fig. 4B is a simplified block diagram of a cross-sectional view of a portion of the IC device of Fig. 4A.
Fig. 5A is a simplified block diagram of a top view of another example IC device that uses a mitigation technique to mitigate adverse effects caused by inductance of wires used in wirebonding, according to another embodiment.
Fig. 5B is a simplified block diagram of a cross-sectional view of a portion of the IC device of Fig. 5A.
Fig. 6A is a simplified block diagram of a top view of another example IC device that uses a mitigation technique to mitigate adverse effects caused by inductance of wires used in wirebonding, according to another embodiment.
Fig. 6B is a simplified block diagram of a cross-sectional view of a portion of the IC device of Fig. 6A.
Fig. 6C is a diagram showing a simplified electrical circuit corresponding to the IC device of Fig. 6A, according to an embodiment.
Fig. 7 is a simplified block diagram of an example communication device in which various aspects, features, and elements described herein are implemented in accordance with various embodiments of this disclosure.
Fig. 8 is a simplified block diagram of another example communication device in which various aspects, features, and elements described herein are implemented in accordance with various embodiments of this disclosure.
Fig. 9 is a flow diagram of an example method of manufacturing an IC device, according to an embodiment.

### Detailed Description

Integrated circuit (IC) devices used in vehicles often employ wirebonding to electrically connect pads on an IC die (or "chip") with traces on a package substrate or with package connection mechanisms (e.g., pins, pads, balls of a ball grid array (BGA), etc.) because wirebonding is typically significantly cheaper than alternative techniques such as "Flip Chip." As the bit rate of data and/or communication signals exchanged between IC devices in vehicles increases, however, other more expensive techniques for electrically connecting pads on an IC chip with traces on a package substrate (e.g., "Flip Chip") are being used because of the limitations of wirebonding technology described above.

Embodiments of techniques that allow use of wirebonding for IC devices that output and/or input high frequency signals are described below. For example, in some embodiments described below, a trace on a package substrate electrically connects i) a wire corresponding to a wirebond, and ii) a package connection mechanism (e.g., a pin, a pad, a BGA ball, etc.), and an effective capacitance is electrically connected to the trace. The effective capacitance mitigates the relatively high inductance of wirebonding connections, and helps to reduce the adverse effects of wirebonding with higher frequency signals, such as high return loss and/or high insertion loss at high frequencies, at least in some embodiments.

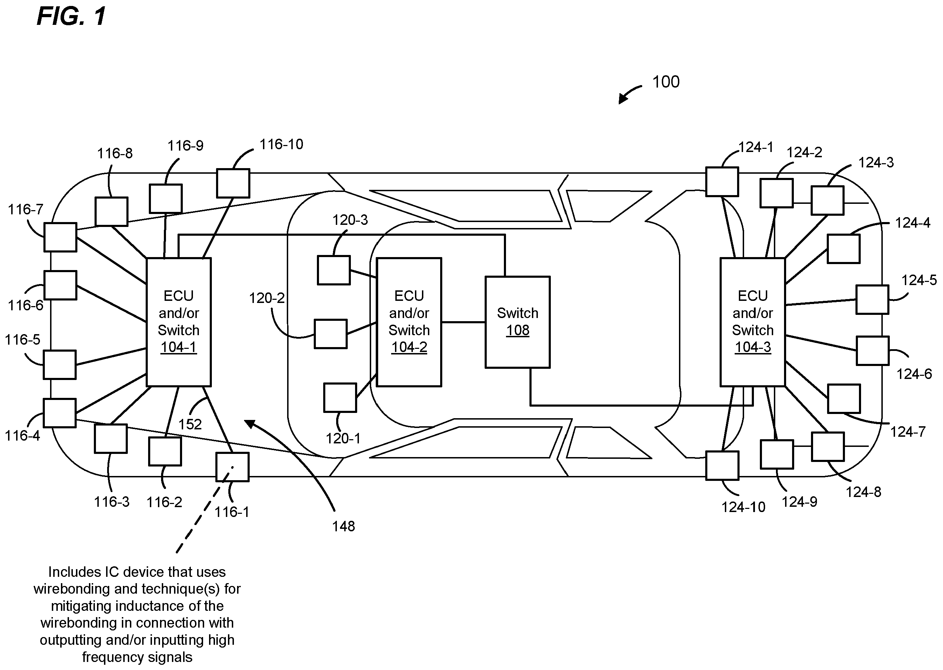

Fig. 1 is a simplified diagram of an example vehicle 100 in which various aspects, features, and elements described herein are implemented in accordance with an embodiment of this disclosure. The vehicle 100 includes a communications network (or simply "network") that enables communication among different subsystems in the vehicle 100. The network includes a plurality of electronic control units (ECUs) 104 communicatively coupled to a network switch 108. In an embodiment, one or more of the ECUs 104 perform operations corresponding to advanced drive assistance (ADAS) functions. In another embodiment, one or more of the ECUs 104 additionally or alternatively perform operations corresponding to in-vehicle infotainment (IVI) functions. In another embodiment, one or more of the ECUs 104 additionally or alternatively perform operations corresponding to engine control and/or monitoring functions. In other embodiments, one or more of the ECUs 104 additionally or alternatively perform other suitable operations.

Although three ECUs 104 are illustrated in Fig. 1, the vehicle 100 includes other suitable numbers of ECUs in other embodiments, such as one, two, four, five, six, etc.

The network switch 108 is communicatively connected to the ECUs 104 via respective communication links. In various embodiments, the communication links correspond to suitable cables such as cables used with Ethernet 100BASE-T1, Ethernet 1000BASE-T1, IEEE 802.3ch compliant Multi-Gig Automotive Ethernet 2.5GBASE-T1, 5GBASE-T1, 10BASE-T1S, cables that conform to the International Organization for Standardization (ISO) Standard 19642-11, etc. In other embodiments, the communication links correspond to other suitable cables.

Each of the ECUs 104 comprises a respective processor (not shown) that executes machine readable instructions stored in a respective memory device (not shown) of the ECU 104, in an embodiment.

Each of one or more of the ECUs 104 also includes a respective network switch, in some embodiments. In another embodiment, none of the ECUs 104 includes a network switch.

The network switch 108 includes a plurality of network interfaces. In an embodiment, a first network interface of the network switch 108 is communicatively connected to a network interface of the ECU 104-1; a second network interface of the network switch 108 is communicatively connected to a network interface of the ECU 104-2; and a third network interface of the network switch 108 is communicatively connected to a network interface of the ECU 104-3.

A network switch of (or communicatively coupled to) the ECU 104-1 is communicatively connected to vehicle subsystem assemblies 116 via respective communication links. In various embodiments, the communication links correspond to suitable cables such as cables described above.

The vehicle subsystem assemblies 116 includes respective Ethernet interface devices and one or more of: i) one or more sensors, ii) one or more actuators, iii) one or more control modules (e.g., comprising a hardware state machine and/or a processor that executes machine readable instructions stored in a memory device), etc., according to various embodiments.

Similarly, a network switch of (or communicatively coupled to) the ECU 104-2 is communicatively connected to vehicle subsystem assemblies 120 via respective communication links; and the network switch of the ECU 104-3 is communicatively connected to vehicle subsystem assemblies 124 via respective communication links.

The vehicle subsystem assemblies 120 and 124 have structures similar to the vehicle subsystem assemblies 116, in an embodiment, but at least some of the subsystem assemblies 116, 120, and 124 correspond to different functionality of the vehicle 100, in some embodiments. For example, at least some of the subsystem assemblies 116 are associated with advanced drive assistance (ADAS) functions and/or engine control and/or monitoring functions; at least some of the subsystem assemblies 120 are associated with in-vehicle infotainment (IVI) functions; and at least some of the subsystem assemblies 124 are associated with hatch operation and/or parking assistance, according to an embodiment. In other embodiments, one or more of the ECUs 104 additionally or alternatively perform other suitable operations.

Each of multiple pairs of devices 104, 116, 120, 124 are connected by a respective cable for communication, in some embodiments. The pairs of devices 104, 116, 120, 124 form communication subsystems. For example, a communication system 148 comprises the ECU/switch 104-1 and the vehicle subsystem assembly 116-1.

The vehicle subsystem assembly 116-1 includes an IC device that utilizes wirebonding, and the IC device uses one or more techniques to mitigate adverse effects of wire inductance for at least one of i) a high-frequency output signal, and ii) a high-frequency input signal. For example, a trace on a package substrate of the IC device electrically connects i) a wire corresponding to a wirebond, and ii) a package connection mechanism (e.g., a pin, a pad, a BGA ball, etc.), and an effective capacitance is electrically connected to the trace, in an embodiment.

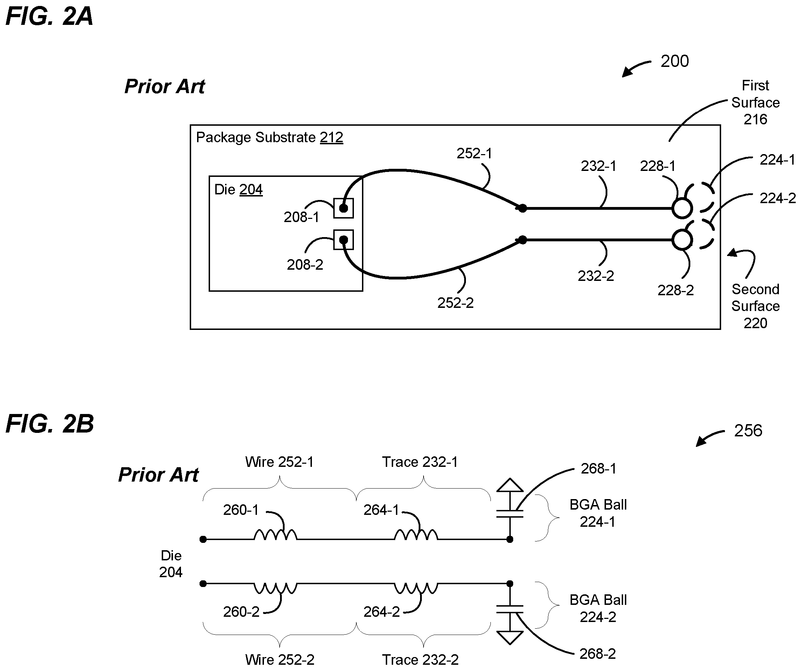

Fig. 2A is a simplified block diagram of a top view of a prior art IC device 200 that uses wirebonding to electrically connect pads on an IC chip with BGA balls of the IC device 200. The IC device 200 includes an IC die 204 having a plurality of pads, including pads 208. Although two pads 208 are illustrated in Fig. 2A, the IC die 204 includes other pads (not shown) for inputting or outputting signals to the IC die 204, providing power to the IC die 204, electrically connecting the IC die 204 to a ground voltage, etc.

The IC die 204 is mounted to a first surface 212 of a package substrate 216. A plurality of BGA balls are formed on a second surface 220 of the package substrate, the plurality of BGA balls including BGA balls 224. Although two BGA balls 224 are illustrated in Fig. 2A, the IC device 200 includes other BGA balls (not shown) for inputting or outputting signals to the IC die 204, providing power to the IC die 204, electrically connecting the IC die 204 to a ground voltage, etc.

The BGA balls 224 are respectively electrically connected to vias 228, which in turn are respectively electrically connected to traces 232. As part of a wirebonding process, a first end of a wire 252-1 is attached to the pad 208-1, and then the wire 252-1 is brought to the trace 232-1 and attached to the trace 232-1. Similarly, a first end of a wire 252-2 is attached to the pad 208-2, and then the wire 252-2 is brought to the trace 232-2 and attached to the trace 232-2. As a result of the wirebonding process, the pad 208-1 is electrically connected to the BGA ball 224-1, and the pad 208-2 is electrically connected to the BGA ball 224-2.

The IC device 200 is encapsulated in a material (not shown), such as plastic or ceramic, to provide mechanical support and protection against environmental factors such as moisture. The encapsulation is such that the BGA balls are exposed to enable electrically connecting the BGA balls to a printed circuit board (PCB).

Fig. 2B is a diagram showing a simplified electrical circuit 256 corresponding to the IC device 200. The wire 252-1 adds an inductance 260-1 to the electrical connection between the pad 208-1 and the BGA ball 224-1, and the wire 252-2 adds an inductance 260-2 to the electrical connection between the pad 208-2 and the BGA ball 224-2. Similarly, the trace 232-1 adds an inductance 264-1 to the electrical connection between the pad 208-1 and the BGA ball 224-1, and the trace 232-2 adds an inductance 264-2 to the electrical connection between the pad 208-2 and the BGA ball 224-2.

The BGA ball 224-1 and/or the via 228-1 add a capacitance 268-1 to the electrical connection between the pad 208-1 and the BGA ball 224-1, and the BGA ball 224-2 and/or the via 228-2 add a capacitance 268-2 to the electrical connection between the pad 208-2 and the BGA ball 224-2.

When the pads 208 input or output high speed signals, the inductance 260 added by the wires 252 can add significant adverse effects, such as significantly increasing insertion loss and/or return loss at high frequencies. Therefore, wirebonding is conventionally avoided for IC devices that are to input and/or output high speed signals. Instead, more expensive IC packaging techniques are used, such as Flip Chip.

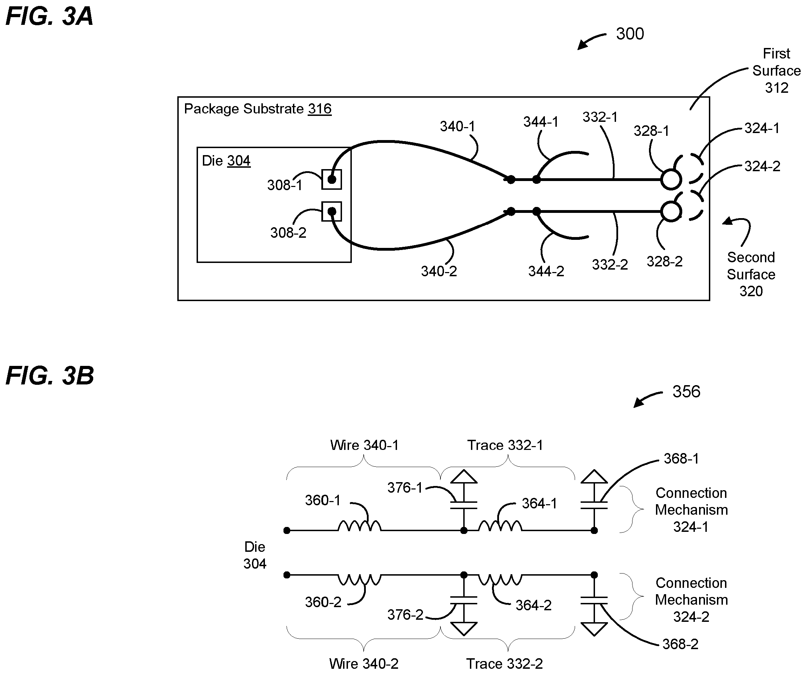

Fig. 3A is a simplified block diagram of a top view of an example IC device 300 that uses wirebonding to electrically connect pads on an IC chip with IC device connection mechanisms of the IC device 300, according to an embodiment. As is described further below, the IC device 300 includes effective capacitances that are electrically connected to traces on a package substrate of the IC device 300. The effective capacitances mitigate relatively high inductance of wirebonding connections, and helps to reduce the adverse effects of wirebonding with higher frequency signals, at least in some embodiments.

The IC device 300 includes an IC die 304 having a plurality of pads, including pads 308. Although two pads 308 are illustrated in Fig. 3A, the IC die 304 includes other pads (not shown) for inputting or outputting signals to the IC die 304, providing power to the IC die 304, electrically connecting the IC die 304 to a ground voltage, etc.

The IC die 304 is configured to generate a high speed differential signal to be output via the pads 308, in an embodiment. For example, the IC die 304 is configured to generate i) a positive component of the high speed differential signal to be output via the pad 308-1 and ii) a negative component of the high speed differential signal to be output via the pad 308-2, in an embodiment.

In another embodiment, the IC die 304 is configured to receive a high speed differential signal via the pads 308, in an embodiment. For example, the IC die 304 is configured to receive i) a positive component of the high speed differential signal via the pad 308-1 and ii) a negative component of the high speed differential signal via the pad 308-2, in an embodiment.

The IC die 304 is mounted to a first surface 312 of a package substrate 316. A second surface 320 of the package substrate 316 is opposite the first surface 312. In an embodiment, the package substrate 316 includes one or more ground planes (not shown) between the first surface 316 and the second surface 320.

The package substrate 316 includes a core board between the first surface 316 and the second surface 320, in an embodiment. In another embodiment, the package substrate 316 is a coreless substrate that omits a core board.

A plurality of IC device connection mechanisms (e.g., pads, pins, BGA balls, etc.) are attached to the second surface 320 of the package substrate, the plurality of IC device connection mechanisms including IC device connection mechanisms 324. Although two IC device connection mechanisms 324 are illustrated in Fig. 3A, the IC device 300 includes other IC device connection mechanisms (not shown) for one or more of i) inputting or outputting signals to the IC die 304, ii) providing power to the IC die 304, iii) electrically connecting the IC die 304 to a ground voltage, etc., according to various embodiments.

The IC device connection mechanisms 324 are respectively electrically connected to vias 328, which in turn are respectively electrically connected to traces 332. The traces 332 are formed on one or more layers of the package substrate 316, with at least a portion of each trace 332 formed on the first surface 312 of the package substrate 316. In some embodiments in which a trace 332 is formed on multiple layers, a first segment of the trace 332 on the first surface 312 is electrically connected to a second segment of the trace 332 on a different layer by a via (not shown) between the first surface 312 and the different layer.

As part of a wirebonding process, a first end of a wire 340-1 is attached to the pad 308-1, and then the wire 340-1 is brought to the trace 332-1 and attached to the trace 332-1. Similarly, a first end of a wire 340-2 is attached to the pad 308-2, and then the wire 340-2 is brought to the trace 332-2 and attached to the trace 332-2. As a result of the wirebonding process, the pad 308-1 is electrically connected to the IC package connection mechanism 324-1, and the pad 308-2 is electrically connected to the IC package connection mechanism 324-2.

The IC device 300 is encapsulated in a material (not shown), such as plastic or ceramic, to provide mechanical support and protection against environmental factors such as moisture. The encapsulation is such that the IC package connection mechanisms are exposed to enable electrically connecting the IC package connection mechanism to a PCB, in at least some embodiments.

In other embodiments, the plurality of IC device connection mechanisms, including the IC device connection mechanisms 324, are attached to the first surface 312 of the package substrate 316. In such embodiments, a via 328 is included if a segment of the corresponding trace 332 that is connected to the via 328 is on a layer of the package substrate different than the first surface 312. In an embodiment, the via 328 is omitted if the corresponding IC device connection mechanism 324 is attached to the first surface 312 and a segment of the corresponding trace 332 that is connected to the IC device connection mechanism 324 is on the first surface 312.

As discussed above, the IC die 304 is configured to one of i) generate a high speed differential signal to be output via the pads 308, or receive a high speed differential signal via the pads 308, in various embodiments. Thus, the wires 340 and the traces 332 carry the high speed differential signal. Each of the wires 340 adds an inductance to the electrical connection between the corresponding pad 308 and the corresponding IC device connection mechanism 324, and the inductance tends to cause adverse effects to the high speed differential signal at high frequencies.

To mitigate the adverse effects caused by the inductance of the wires 340, the package substrate 316 includes metallic structures 344 that are respectively electrically connected to the traces 332 and that add respective effective capacitances to the electrical connections between the pads 308 and the corresponding IC device connection mechanisms 324. In the example of Fig. 3A, the metallic structures 344 comprise trace stubs, but as described below suitable metallic structures other than traces stubs are used in other embodiments.

Fig. 3B is a diagram showing a simplified electrical circuit 356 corresponding to the IC device 300. The wire 340-1 adds an inductance 360-1 to the electrical connection between the pad 308-1 and the IC device connection mechanism 324-1, and the wire 340-2 adds an inductance 360-2 to the electrical connection between the pad 308-2 and the IC device connection mechanism 324-2. Similarly, the trace 332-1 adds an inductance 364-1 to the electrical connection between the pad 308-1 and the IC device connection mechanism 324-1, and the trace 332-2 adds an inductance 364-2 to the electrical connection between the pad 308-2 and the IC device connection mechanism 324-2.

The IC device connection mechanism 324-1 and/or the via 328-1 add a capacitance 368-1 to the electrical connection between the pad 308-1 and the IC device connection mechanism 324-1, and the IC device connection mechanism 324-2 and/or the via 328-2 add a capacitance 368-2 to the electrical connection between the pad 308-2 and the IC device connection mechanism 324-2.

The trace stub 344-1 adds a capacitance 376-1 to the electrical connection between the pad 308-1 and the IC device connection mechanism 324-1, and trace stub 344-2 adds a capacitance 376-2 to the electrical connection between the pad 308-2 and the IC device connection mechanism 324-2. The capacitances 376 mitigate the adverse effects caused by the inductances 360 at high frequencies and improve insertion loss and/or return loss at high frequencies, at least in some embodiments.

The amount of capacitance 376 and/or a degree of performance improvement (e.g., insertion loss improvement, return loss improvement, etc.) can be tuned by adjusting one or more of i) a length of the trace stub 344, ii) a width of the trace stub 344, iii) a distance from a) a point at which the wire 340 is attached to the trace 332 and b) a point at which the trace stub 344 is connected to the trace 332, etc., according to various embodiments.

Although Fig. 3A illustrates the trace stubs 344 having particular shapes (e.g., curved), other suitable shapes of the trace stubs 344 can be used for different applications, at least in some embodiments. For example, the trace stubs 344 are straight, in an embodiment. As another example, a trace stub 344 comprises two or more straight segments connected at one or more angles (that are not 180 degrees), in another embodiment. Generally, the shapes of the trace stubs 344 can be configured to fit within a particular layout of the package substrate 316, in some embodiments.

As mentioned above, a metallic structure other than a trace stub is used to add an effective capacitance (i.e., the capacitance 376) to the electrical connection between a pad 308 and the IC device connection mechanism 324, in other embodiments.

In the example of Fig. 3A, the metallic structures 344 comprise trace stubs, but as described below suitable metallic structures other than traces stubs are used in other embodiments.

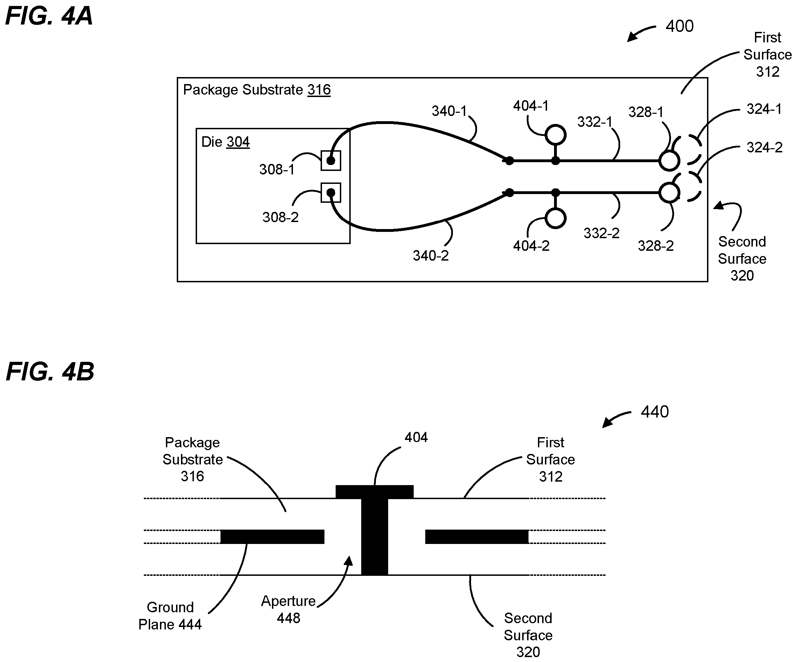

Fig. 4A is a simplified block diagram of a top view of another example IC device 400 that uses wirebonding to electrically connect pads on an IC chip with IC device connection mechanisms of the IC device 400, according to another embodiment. The IC device 400 is similar to the IC device 300 of Fig. 3A, and like-numbered elements are not described again in detail for purposes of brevity.

In the IC device 400, the trace stubs 344 are replaced by vias 404, which add the effective capacitances 376 (Fig. 3B). More specifically, each via 404 is electrically connected to the respective trace 332. As discussed above, the effective capacitances 376 mitigate relatively high inductance of wirebonding connections, and helps to reduce the adverse effects of wirebonding with higher frequency signals, at least in some embodiments.

Fig. 4B is a simplified block diagram of a cross-sectional view of a portion 440 of the IC device 400, the portion 440 including one of the vias 404. The via 404 extends from the first surface 312 of the package substrate 316 to the second surface 320 of the package substrate 316. In other embodiments, the via 404 has a length that is less than the thickness of the package substrate 316 and does not extend to the second surface 320 of the package substrate 316.

The package substrate 316 includes a ground plane 444, and the via 404 extends through an aperture 448 in the ground plane 444. Thus, the via 404 is electrically isolated from the ground plane 444, in an embodiment.

The amount of capacitance 376 and/or a degree of performance improvement (e.g., insertion loss improvement, return loss improvement, etc.) can be tuned by adjusting one or more of i) a length of the via 404, ii) a diameter of the via 404, iii) a distance from a) a point at which the wire 340 is attached to the trace 332 and b) a point at which the via 404 is connected to the trace 332, etc., according to various embodiments.

In other embodiments, other suitable vias different than the vias 404 are utilized. For example, micro vias, blind vias, buried vias, etc., are used in other embodiments.

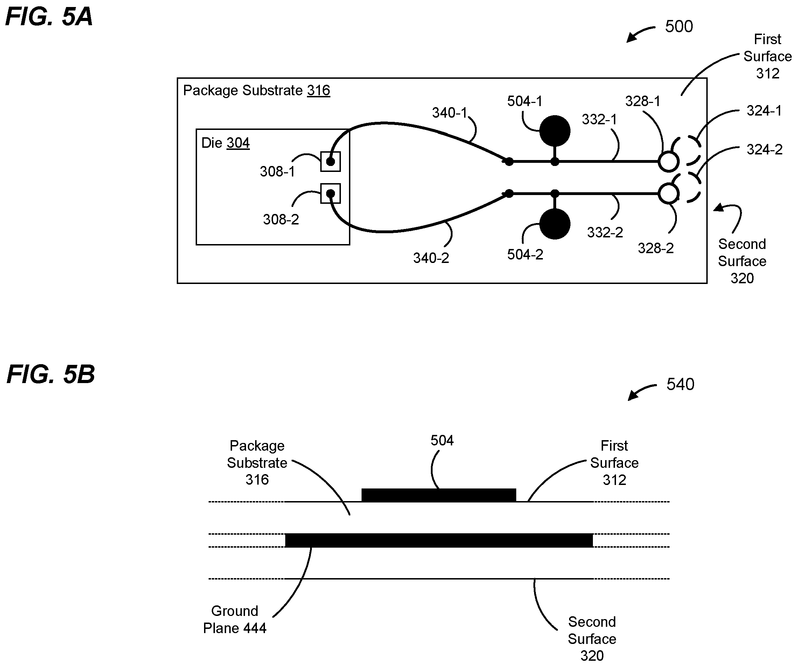

Fig. 5A is a simplified block diagram of a top view of another example IC device 500 that uses wirebonding to electrically connect pads on an IC chip with IC device connection mechanisms of the IC device 500, according to another embodiment. The IC device 500 is similar to the IC device 300 of Fig. 3A and the IC device 400 of Figs. 4A-B, and like-numbered elements are not described again in detail for purposes of brevity.

In the IC device 500, the trace stubs 344 are replaced by pads 504, which add the effective capacitances 376 (Fig. 3B). More specifically, each pad 504 is electrically connected to the respective trace 332. As discussed above, the effective capacitances 376 mitigate relatively high inductance of wirebonding connections, and helps to reduce the adverse effects of wirebonding with higher frequency signals, at least in some embodiments.

Fig. 5B is a simplified block diagram of a cross-sectional view of a portion 540 of the IC device 500, the portion 540 including one of the pads 504. The pad 504 is fabricated on the first surface 312 of the package substrate 316. The package substrate 316 includes a ground plane 444, and the pad 504 is fabricated over the ground plane 444. The pad 504 is electrically isolated from the ground plane 444.

The amount of capacitance 376 and/or a degree of performance improvement (e.g., insertion loss improvement, return loss improvement, etc.) can be tuned by adjusting one or more of i) an area of the pad 504, ii) a distance from a) a point at which the wire 340 is attached to the trace 332 and b) a point at which the pad 504 is connected to the trace 332, etc., according to various embodiments.

Although the pad 504 is illustrated in Fig. 5A as having a circular shape, the pad 504 has another suitable shape, such as square, rectangular, oval, etc., according to other embodiments.

Although Fig. 5B illustrates the pad 504 on the first surface 312 of the package substrate 316, the pad 504 is fabricated on an internal layer below the first surface 312 in other embodiments. In one embodiment in which the pad 504 is fabricated on an internal layer below the first surface 312, the pad 504 is located over a ground plane of the package substrate 316, e.g., the ground plane 444 or another ground plane. In another embodiment in which the pad 504 is fabricated on an internal layer below the first surface 312, the pad 504 is located below a ground plane of the package substrate 316, e.g., the ground plane 444 or another ground plane. In another embodiment in which the pad 504 is fabricated on an internal layer below the first surface 312, the pad 504 is located above a first ground plane and below a second ground plane of the package substrate 316.

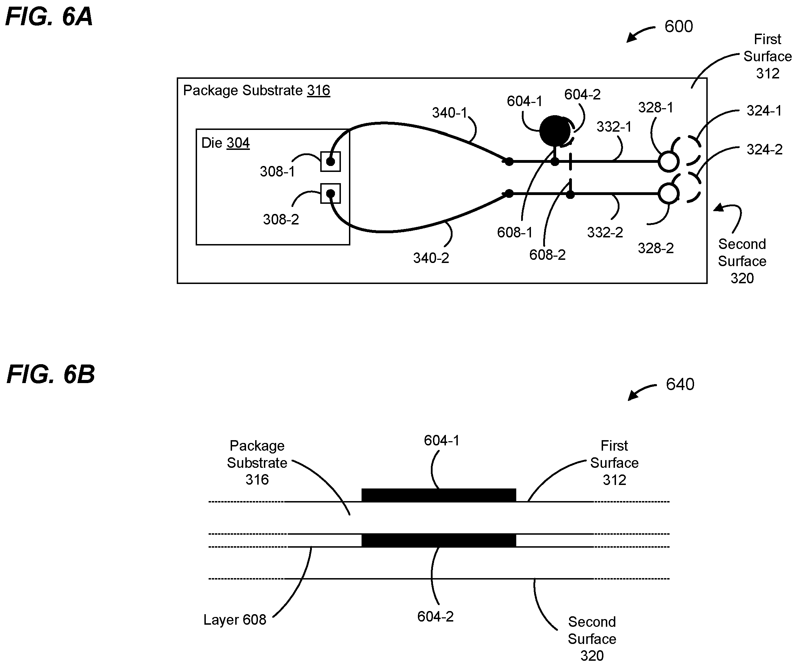

Fig. 6A is a simplified block diagram of a top view of another example IC device 600 that uses wirebonding to electrically connect pads on an IC chip with IC device connection mechanisms of the IC device 600, according to another embodiment. The IC device 600 is similar to the IC device 300 of Fig. 3A and the IC device 500 of Figs. 5A-B, and like-numbered elements are not described again in detail for purposes of brevity.

In the IC device 600, a pad 604-1 is electrically connected to the trace 332-1 by a trace segment 608-1, and a pad 604-2 is electrically connected to the trace 332-2 by a trace segment 608-2. The pads 604 add an effective capacitance, as is described further below. The effective capacitance mitigates relatively high inductance of wirebonding connections, and helps to reduce the adverse effects of wirebonding with higher frequency signals, at least in some embodiments. In an embodiment, a first electrical length of the trace segment 608-1 equals a second electrical length of the trace segment 608-2 to help ensure symmetry in a routing of a differential signal from the pads 308 of the die 304 to the IC device connection mechanisms 324.

Fig. 6B is a simplified block diagram of a cross-sectional view of a portion 640 of the IC device 600, the portion 640 including the pads 604. The pad 604-1 is fabricated on the first surface 312 of the package substrate 316, and the pad 604-2 is fabricated on a layer 608 of the package substrate 316 that is below the first surface 312. The pad 604-1 is vertically aligned with the pad 604-2 and is electrically isolated from the pad 604-2.

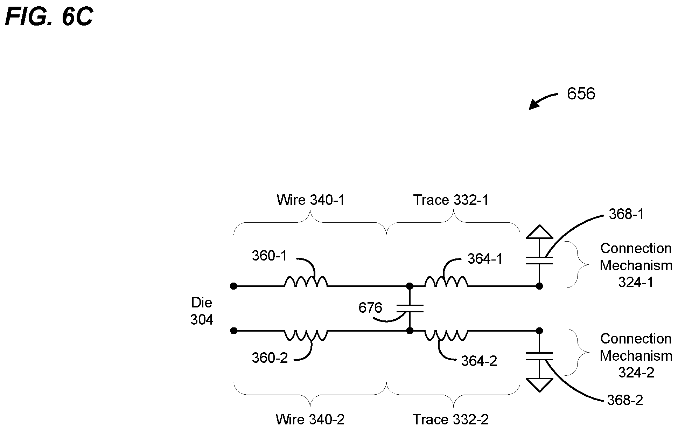

Fig. 6C is a diagram showing a simplified electrical circuit 656 corresponding to the IC device 600. The electrical circuit 656 is similar to the electrical circuit 356 of Fig. 3B, and like-numbered elements are not described again in detail for purposes of brevity.

The pads 604 add a capacitance 676 between the traces 332. The capacitance 676 mitigates the adverse effects caused by the inductances 360 at high frequencies and improve insertion loss and/or return loss at high frequencies, at least in some embodiments.

The amount of capacitance 676 and/or a degree of performance improvement (e.g., insertion loss improvement, return loss improvement, etc.) can be tuned by adjusting one or more of i) area of each pads 604, ii) a distance from a) a point at which the wire 340 is attached to the trace 332 and b) a point at which the pad 604 is connected to the trace 332, etc., according to various embodiments.

Although the pads 604 are illustrated in Fig. 6A as having a circular shape, the pads 604 has another suitable shape, such as square, rectangular, oval, etc., according to other embodiments.

Although Figs. 3A-5B were described in the context of an IC chip inputting or outputting differential signals, similar techniques are used for an IC chip inputting or outputting single-ended signals, in some embodiments.

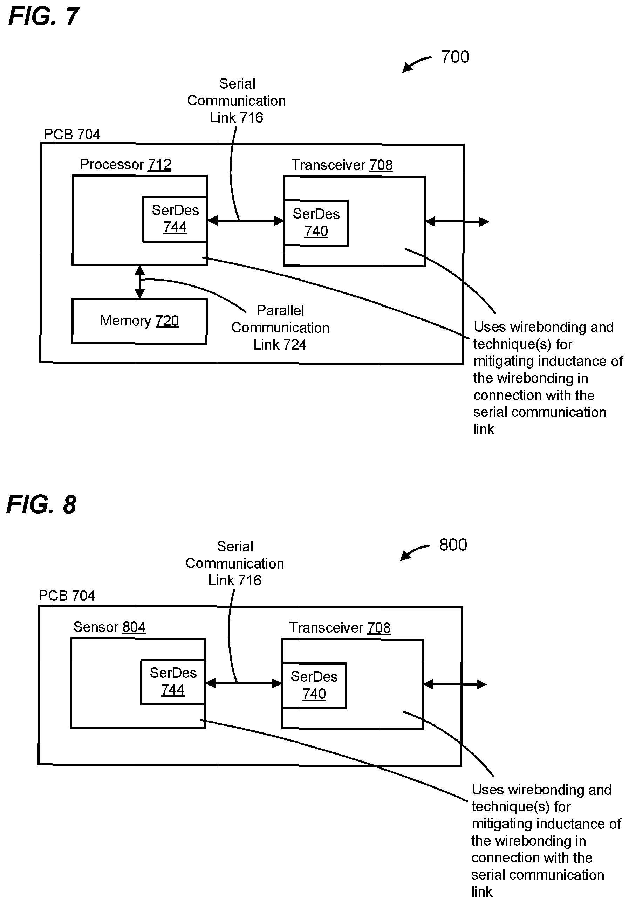

Fig. 7 is a simplified block diagram of an example communication device 700 in which various aspects, features, and elements described herein are implemented in accordance with various embodiments of this disclosure. The communication device 700 corresponds to an ECU of a vehicle, such as one of the ECUs 104 in the vehicle 100 (Fig. 1), in an embodiment. In other embodiments, ECUs 104 have a suitable structure different than the communication device 700. In some embodiments, the communication device 700 is utilized in a suitable system different than the vehicle of Fig. 1, such as a personal computer, a server, a network device such as a network switch, a cable set-top box, a consumer appliance, etc.

The communication device 700 includes a printed circuit board (PCB) 704. A first IC device 708 is mounted on the PCB 704. The first IC device 708 includes a transceiver, and the first IC device 708 is referred to in Fig. 7 as "the transceiver 708." The transceiver 708 is configured to communicate via a suitable wired communication medium such as a cable, in some embodiments. In other embodiments, the transceiver 708 comprises a wireless transceiver, such as a WiFi transceiver, a mobile telephony transceiver, a satellite transceiver, etc.

A second IC device 712 is also mounted on the PCB 704 and is communicatively coupled to the transceiver 708 via a serial communication link 716. The second IC device 712 includes a processor, and the second IC device 712 is referred to in Fig. 7 as "the processor 712." In an embodiment, the processor 1424 is configured to execute machine readable instructions stored in a memory 720, which is communicatively coupled to the processor 720 via a parallel communication link 724. In an embodiment, the memory 720 is included in the second IC device 712. In another embodiment, the memory 720 is included in a third IC device.

In an embodiment, the communication device 700 corresponds to an ECU, and the memory 720 stores machine readable instructions that, when executed by the processor 712, cause the processor 712 to perform operations corresponding to functionality of the ECU.

In another embodiment, the communication device 700 corresponds to a network switch. In some embodiments in which the communication device 700 corresponds to a network switch, the processor 712 is a processor configured to process headers of packets received via a plurality of transceivers (including the transceiver 708) communicatively connected to the processor 712 to determine transceivers via which the packets are to be forwarded; and the memory 720 stores packet data of packets being processed by the packet processor 712.

The transceiver 708 is configured to: i) a) receive transmit data from the processor 712 via the serial communication link 716, b) generate a transmit signal for transmission via a communication medium; and ii) a) receive a receive signal via the communication medium, b) decode receive data from the receive signal, and c) provide the receive data to the processor 712 via the serial communication link 716, in an embodiment.

The transceiver 708 includes a serializer/deserializer (SerDes) 740 that is configured to: i) receive a first differential signal from the processor 712 via the serial communication link 716, and ii) transmit a second differential signal to the processor 712 via the serial communication link 716. The processor includes a SerDes 744 that is configured to: i) receive the second differential signal from the transceiver 708 via the serial communication link 716, and ii) transmit the first differential signal to the transceiver 708 via the serial communication link 716.

The transceiver 708 (first IC device 708) has a structure the same as or similar to the IC devices of Figs. 3A-6C, according to various embodiments. For example, the first IC device 708 includes two package connection mechanisms (e.g., pins, pads, BGA balls, etc.) corresponding to the two signal components of the serial communication link 716; and wirebonding is used to electrically connect the two package connection mechanisms to pads of an IC chip of the first IC device 708, the pads corresponding to the SerDes 740. In another embodiment, the transceiver 708 (first IC device 708) does not use wirebonding but instead uses another suitable technique to electrically connect the two package connection mechanisms to pads of the IC chip of the first IC device 708, such as Flip Chip.

The processor 712 (second IC device 712) has a structure the same as or similar to the IC devices of Figs. 3A-6C, according to various embodiments. For example, the second IC device 712 includes two package connection mechanisms (e.g., pins, pads, BGA balls, etc.) corresponding to the two signal components of the serial communication link 716; and wirebonding is used to electrically connect the two package connection mechanisms to pads of an IC chip of the second IC device 712, the pads corresponding to the SerDes 744. In another embodiment, the processor 712 (second IC device 712) does not use wirebonding but instead uses another suitable technique to electrically connect the two package connection mechanisms to pads of the IC chip of the second IC device 712, such as Flip Chip.

Additionally or alternatively, in embodiments in which the memory 720 corresponds to a third IC device, the second IC device 712 (processor 712) includes package connection mechanisms (e.g., pins, pads, BGA balls, etc.) corresponding to the signals of the parallel communication link 724; and wirebonding is used to electrically connect the package connection mechanisms to pads of the IC chip of the second IC device 712, the pads corresponding to a memory interface circuit configured to communicate with the memory 720 via the parallel communication link 724.

Fig. 8 is a simplified block diagram of another example communication device 800 in which various aspects, features, and elements described herein are implemented in accordance with various embodiments of this disclosure. The communication device 800 corresponds to a vehicle subsystem assembly having a sensor device, such as one of the vehicle subsystem assemblies 116, 120, 124 in the vehicle 100 (Fig. 1), in an embodiment. In other embodiments, the vehicle subsystem assemblies 116, 120, 124 have a suitable structure different than the communication device 800. In some embodiments, the communication device 800 is utilized in a suitable system different than the vehicle of Fig. 1, such as a sensor device in an industrial plant, a sensor device in a security system, a consumer electronic device, a consumer appliance, etc.

The communication device 800 is similar to the communication device 700 of Fig. 7 and like-numbered elements are not described again in detail for purposes of brevity.

The communication device 800 includes a first IC device 804 mounted on the PCB 704. The first IC device 708 includes a sensor device, and the first IC device 804 is referred to in Fig. 8 as "the sensor 804." The sensor 804 is coupled to the transceiver 708. The sensor 804 comprises a camera sensor, a lidar sensor, a radar sensor, etc., in various embodiments. The sensor 804 comprises another suitable sensor in other embodiments.

The sensor 804 is configured to: i) transmit sensor data to the transceiver 708 via the serial communication link 716, and ii) receive control data and/or configuration data from the transceiver 708 via the serial communication link 716. More specifically, the SerDes 744 transmits sensor data to the transceiver 708 via the serial communication link 716, and ii) receives control data and/or configuration data from the transceiver 708 via the serial communication link 716, in an embodiment.

The transceiver 708 is configured to: i) a) receive sensor data from the sensor 804 via the serial communication link 716, b) generate a transmit signal based on the sensor data for transmission via a communication medium; and ii) a) receive a receive signal from via the communication medium, b) decode control data and/or configuration data from the receive signal, and c) provide the control data and/or configuration data to the sensor 804 via the serial communication link 716, in an embodiment.

The sensor 804 (second IC device 804) has a structure the same as or similar to the IC devices of Figs. 3A-6C, according to various embodiments. For example, the second IC device 804 includes two package connection mechanisms (e.g., pins, pads, BGA balls, etc.) corresponding to the two signal components of the serial communication link 716; and wirebonding is used to electrically connect the two package connection mechanisms to pads of an IC chip of the second IC device 712, the pads corresponding to the SerDes 744. In another embodiment, the processor 712 (second IC device 712) does not use wirebonding but instead uses another suitable technique to electrically connect the two package connection mechanisms to pads of the IC chip of the second IC device 712, such as Flip Chip.

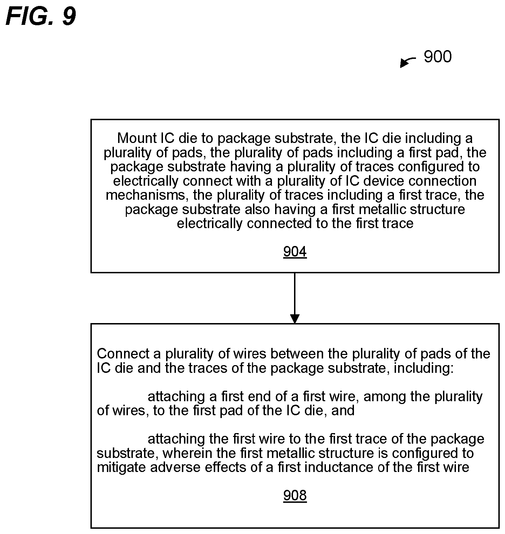

Fig. 9 is a flow diagram of an example method 900 of manufacturing an IC device, according to an embodiment. The method 900 is performed in connection with manufacturing any of the IC devices described above in connection with Figs. 3A-8, in some embodiments, and Fig. 9 is described with reference to some of Figs. 3A-8 merely for explanatory purposes. The method 900 is performed in connection with manufacturing a suitable IC device that is different than the IC devices described above in connection with Figs. 3A-8, in other embodiments.

At block 904, an IC die is mounted to a package substrate. The IC die includes a plurality of pads, which includes a first pad, and the package substrate includes a plurality of traces configured to electrically connect with a plurality of IC device connection mechanisms. For example, the IC die 312 includes pads 308, and the substrate 312 includes traces 332 configured to electrically connect with IC device connection mechanisms 324.

The plurality of traces of the package substrate includes a first trace, and the package substrate also has a first metallic structure electrically connected to the first trace. For example, trace stubs 344 are respectively electrically connected to the traces 332. As another example, vias 404 are respectively electrically connected to the traces 332. As another example, pads 504 are respectively electrically connected to the traces 332. As another example, the pad 604-1 is electrically connected to the trace 332-1. As another example, the pad 604-2 is electrically connected to the trace 332-2.

At block 908, a plurality of wires are connected between the plurality of pads of the IC die and the traces of the package substrate. Connecting the plurality of wires at block 908 includes: i) attaching a first end of a first wire, among the plurality of wires, to the first pad of the IC die, and ii) attaching the first wire to the first trace of the package substrate, wherein the first metallic structure is configured to mitigate adverse effects of a first inductance of the first wire.

For example, the wires 340 respectively electrically connect the pads 308 to the traces 332, and the trace stubs 344 mitigate adverse effects of the inductances of the wires 340. As another example, the vias 404 mitigate adverse effects of the inductances of the wires 340. As another example, the pads 504 mitigate adverse effects of the inductances of the wires 340. As another example, the pads 604 mitigate adverse effects of the inductances of the wires 340.

In another embodiment, the method 900 further includes fabricating the package substrate to include the plurality of traces and the first metallic structure.

In another embodiment, the method 900 further includes encapsulating the IC die and the package substrate in an encapsulating material.

In another embodiment, the method 900 further includes electrically connecting the plurality of IC device connection mechanisms to the plurality of traces.

Embodiment 1: An integrated circuit (IC) device, comprising: a package substrate having a plurality of traces configured to electrically connect with a plurality of IC device connection mechanisms, the plurality of traces including a first trace, the package substrate also having a first metallic structure electrically connected to the first trace; an IC die mounted on the package substrate, the IC die including a plurality of pads, the plurality of pads including a first pad; and a plurality of wires, each wire of the plurality of wires i) including a respective end attached to a respective pad of the IC die, and ii) being attached to a respective trace among the plurality of traces of the package substrate, the plurality of wires including a first wire electrically connecting the first pad of the IC die to the first trace of the package substrate, wherein the first metallic structure is configured to mitigate adverse effects of a first inductance of the first wire.

Embodiment 2: The IC device of embodiment 1, wherein the first metallic structure comprises a trace stub.

Embodiment 3: The IC device of embodiment 2, wherein: the IC die mounted on a first surface of the package substrate; and the trace stub is fabricated on the first surface of the package substrate.

Embodiment 4: The IC device of embodiment 1, wherein the first metallic structure comprises a via in the package substrate.

Embodiment 5: The IC device of embodiment 1, wherein the first metallic structure comprises a pad.

Embodiment 6: The IC package of embodiment 5, wherein: the IC die mounted on a first surface of the package substrate; and the pad is on the first surface.

Embodiment 7: The IC device of embodiment 5, wherein: the IC die mounted on a first surface of the package substrate; the package substate includes a plurality of layers, the plurality of layers including a first layer below the first surface; and the pad is within the first layer.

Embodiment 8: The IC device of any of embodiments 1-7, wherein: the plurality of traces of the package substrate further includes a second trace; the package substrate further includes a second metallic structure electrically connected to the second trace; the plurality of pads of the IC die further includes a second pad; the plurality of wires further includes a second wire electrically connecting the second pad of the IC die to the second trace of the package substrate, wherein the second metallic structure is configured to mitigate adverse effects of a second inductance of the second wire.

Embodiment 9: The IC device of embodiment 8, wherein: the second metallic structure comprises a second trace stub.

Embodiment 10: The IC device of embodiment 8, wherein: the second metallic structure comprises a second via.

Embodiment 11: The IC device of embodiment 8, wherein: the second metallic structure comprises a second pad.

Embodiment 12: The IC device of embodiment 11, wherein: the IC die mounted on a first surface of the package substrate; and the second pad is on the first surface.

Embodiment 13: The IC device of embodiment 11, wherein: the IC die mounted on a first surface of the package substrate; the package substate includes a plurality of layers, the plurality of layers including a first layer below the first surface; the second pad is in the first layer.

Embodiment 14: The IC device of any of embodiments 1-13, further comprising. an encapsulating material that encapsulates the IC die and the package substrate.

Embodiment 15: A method for manufacturing an integrated circuit (IC) device, comprising: mounting an IC die to a package substrate, the IC die including a plurality of pads, the plurality of pads including a first pad, the package substrate having a plurality of traces configured to electrically connect with a plurality of IC device connection mechanisms, the plurality of traces including a first trace, the package substrate also having a first metallic structure electrically connected to the first trace; and connecting a plurality of wires between the plurality of pads of the IC die and the traces of the package substrate, including: attaching a first end of a first wire, among the plurality of wires, to the first pad of the IC die, and attaching the first wire to the first trace of the package substrate, wherein the first metallic structure is configured to mitigate adverse effects of a first inductance of the first wire.

Embodiment 16: The method of embodiment 15, wherein the first metallic structure comprises a trace stub.

Embodiment 17: The method of embodiment 16, wherein: mounting the IC die to the package substrate comprises mounting the IC die on a first surface of the package substrate; and the trace stub is fabricated on the first surface of the package substrate.

Embodiment 18: The method of embodiment 15, wherein the first metallic structure comprises a via in the package substrate.

Embodiment 19: The method of embodiment 15, wherein the first metallic structure comprises a pad.

Embodiment 20: The method of embodiment 19, wherein: mounting the IC die to the package substrate comprises mounting the IC die on a first surface of the package substrate; and the pad is fabricated on the first surface of the package substrate.

Embodiment 21: The method of embodiment 19, wherein: mounting the IC die to the package substrate comprises mounting the IC die on a first surface of the package substrate; the package substate includes a plurality of layers, the plurality of layers including a first layer below the first surface; and the pad is within the first layer.

Embodiment 22: The method of any of embodiments 15-21, wherein: the plurality of traces of the package substrate further includes a second trace; the package substrate further includes a second metallic structure electrically connected to the second trace; the plurality of pads of the IC die further includes a second pad; connecting the plurality of wires between the plurality of pads of the IC die and the traces of the package substrate, further includes: attaching a first end of a second wire, among the plurality of wires, to the second pad of the IC die, and attaching the second wire to the second trace of the package substrate, wherein the second metallic structure is configured to mitigate adverse effects of a second inductance of the second wire.

Embodiment 23: The method of embodiment 22, wherein: the second metallic structure comprises a second trace stub.

Embodiment 24: The method of embodiment 22, wherein: the second metallic structure comprises a second via.

Embodiment 25: The method of embodiment 22, wherein: the second metallic structure comprises a second pad.

Embodiment 26: The method of embodiment 25, wherein: the IC die mounted on a first surface of the package substrate; and the second pad is on the first surface.

Embodiment 27: The method of embodiment 25, wherein: the IC die mounted on a first surface of the package substrate; the package substate includes a plurality of layers, the plurality of layers including a first layer below the first surface; the second pad is in the first layer.

Embodiment 28: The method of any of embodiments 15-27, further comprising: fabricating the package substrate to include the plurality of traces and the first metallic structure.

Embodiment 29: The method of any of embodiments 15-28, further comprising: encapsulating the IC die and the package substrate in an encapsulating material.

Embodiment 30: The method of any of embodiments 15-29, further comprising: electrically connecting the plurality of IC device connection mechanisms to the plurality of traces.

Some of the various blocks, operations, and techniques described above may be implemented utilizing hardware, a processor executing firmware instructions, a processor executing software instructions, or any suitable combination thereof. When implemented utilizing a processor executing software or firmware instructions, the software or firmware instructions may be stored in any suitable computer readable memory. The software or firmware instructions may include machine readable instructions that, when executed by one or more processors, cause the one or more processors to perform various acts such as described above.

When implemented in hardware, the hardware may comprise one or more of discrete components, an integrated circuit, an application-specific integrated circuit (ASIC), a programmable logic device (PLD), etc.

While the present invention has been described with reference to specific examples, which are intended to be illustrative only and not to be limiting of the invention, changes, additions and/or deletions may be made to the disclosed embodiments without departing from the scope of the invention.

## Claims

1. An integrated circuit (IC) device, comprising:
a package substrate having a plurality of traces configured to electrically connect with a plurality of IC device connection mechanisms, the plurality of traces including a first trace, the package substrate also having a first metallic structure electrically connected to the first trace;
an IC die mounted on the package substrate, the IC die including a plurality of pads, the plurality of pads including a first pad; and
a plurality of wires, each wire of the plurality of wires i) including a respective end attached to a respective pad of the IC die, and ii) being attached to a respective trace among the plurality of traces of the package substrate, the plurality of wires including a first wire electrically connecting the first pad of the IC die to the first trace of the package substrate, wherein the first metallic structure is configured to mitigate adverse effects of a first inductance of the first wire.

2. The IC device of claim 1, wherein the first metallic structure comprises a trace stub.

3. The IC device of claim 2, wherein:
the IC die mounted on a first surface of the package substrate; and
the trace stub is fabricated on the first surface of the package substrate.

4. The IC device of claim 1, wherein the first metallic structure comprises a via in the package substrate.

5. The IC device of claim 1, wherein the first metallic structure comprises a pad.

6. The IC package of claim 5, wherein:
the IC die mounted on a first surface of the package substrate; and
the pad is on the first surface.

7. The IC device of claim 5, wherein:
the IC die mounted on a first surface of the package substrate;
the package substate includes a plurality of layers, the plurality of layers including a first layer below the first surface; and
the pad is within the first layer.

8. The IC device of any one of claims 1-7, wherein:
the plurality of traces of the package substrate further includes a second trace;
the package substrate further includes a second metallic structure electrically connected to the second trace;
the plurality of pads of the IC die further includes a second pad;
the plurality of wires further includes a second wire electrically connecting the second pad of the IC die to the second trace of the package substrate, wherein the second metallic structure is configured to mitigate adverse effects of a second inductance of the second wire.

9. The IC device of claim 8, wherein:
the first metallic structure comprises a first pad; and
the second metallic structure comprises a second pad.

10. The IC device of claim 9, wherein:
the IC die is mounted on a first surface of the package substrate;
the first pad is on the first surface; and
the second pad is on the first surface, or
the package substate includes a plurality of layers, the plurality of layers including a first layer below the first surface, and the second pad is in the first layer.

11. The IC device of any one of claims 1-10, further comprising.
an encapsulating material that encapsulates the IC die and the package substrate.

12. A method for manufacturing an integrated circuit (IC) device, comprising:
mounting an IC die to a package substrate, the IC die including a plurality of pads, the plurality of pads including a first pad, the package substrate having a plurality of traces configured to electrically connect with a plurality of IC device connection mechanisms, the plurality of traces including a first trace, the package substrate also having a first metallic structure electrically connected to the first trace; and
connecting a plurality of wires between the plurality of pads of the IC die and the traces of the package substrate, including:
attaching a first end of a first wire, among the plurality of wires, to the first pad of the IC die, and
attaching the first wire to the first trace of the package substrate, wherein the first metallic structure is configured to mitigate adverse effects of a first inductance of the first wire.

13. The method of claim 12, wherein one of:
the first metallic structure comprises a trace stub;
the first metallic structure comprises a via in the package substrate; and
the first metallic structure comprises a pad.

14. The method of either of claims 12 or 13, wherein:
the plurality of traces of the package substrate further includes a second trace;
the package substrate further includes a second metallic structure electrically connected to the second trace;
the plurality of pads of the IC die further includes a second pad;
connecting the plurality of wires between the plurality of pads of the IC die and the traces of the package substrate, further includes:
attaching a first end of a second wire, among the plurality of wires, to the second pad of the IC die, and
attaching the second wire to the second trace of the package substrate, wherein the second metallic structure is configured to mitigate adverse effects of a second inductance of the second wire.

15. The method of any one of claims 12-14, further comprising one or more of:
fabricating the package substrate to include the plurality of traces and the first metallic structure;
encapsulating the IC die and the package substrate in an encapsulating material; and.
electrically connecting the plurality of IC device connection mechanisms to the plurality of traces.
